# EUROPEAN PATENT SPECIFICATION

(11) **EP 4 518 628 B1**
(45) Date of publication and mention of the grant of the patent: **13.05.2026**
(21) Application number: 24195783.6
(22) Date of filing: 22.08.2024
(51) Int. Cl.: H10K 59/131, H10K 59/126, H10K 59/121

(54) **DISPLAY PANEL**
ANZEIGETAFEL
PANNEAU D'AFFICHAGE

(30) Priority: 24.08.2023 KR 20230111147
(43) Date of publication of application: 05.03.2025
(73) Proprietor: Samsung Display Co., Ltd, Yongin-si, Gyeonggi-Do (KR)
(72) Inventor: Cheon, Soohong, Yongin-si, Gyeonggi-Do (KR)
(74) Representative: Gulde & Partner

(56) References cited:
- US-A1- 2023 141 774
- US-A1- 2023 247 878

## Description

### BACKGROUND

Embodiments of the disclosure relate to a display panel and to a display panel including a circuit element having improved reliability.

A display panel includes pixels and a driving circuit (e.g., a scan driving circuit and a data driving circuit) that controls the pixels. Each of the pixels includes a display element and a pixel driving circuit that controls the display element. The pixel driving circuit may include organically connected transistors and at least one capacitor.

US2023247878A1 and US2023141774A1 disclose driving circuits of display panels comprising transistors and at least one capacitor.

### SUMMARY

Embodiments of the disclosure provide a display panel having improved display quality.

According to the present claimed invention, a display panel includes a base layer, data lines arranged on the base layer, spaced apart from each other in a first direction, and each extending in a second direction intersecting the first direction, and a unit pixel electrically connected to the data lines and including a first pixel, a second pixel, and a third pixel that each provide a light to a pixel area, wherein the first pixel includes a common electrode including a first lower electrode, a light shielding pattern, and a second lower electrode sequentially arranged in the second direction, a first upper electrode that overlaps the first lower electrode and forms a first capacitor with the first lower electrode, a second upper electrode that overlaps the second lower electrode and forms a second capacitor with the second lower electrode, a first transistor including an active pattern overlapping the light shielding pattern and a gate electrode overlapping the active pattern, and a light emitting element electrically connected to the first transistor, and an end of the gate electrode is electrically connected to the first upper electrode, and another end of the gate electrode, which is spaced apart from the end in the second direction, is electrically connected to the second upper electrode.

The display panel may further include a first insulating layer that is disposed on the base layer and covers the common electrode, a second insulating layer that is disposed on the first insulating layer and covers the first upper electrode and the second upper electrode, and a third insulating layer disposed on the second insulating layer, wherein the end of the gate electrode may be electrically connected to the first upper electrode through a first contact hole defined in the second insulating layer, and the another end of the gate electrode may be electrically connected to the second upper electrode through a second contact hole defined in the second insulating layer.

The active pattern, the first upper electrode, and the second upper electrode may be disposed on a same layer.

The active pattern may be disposed between the first upper electrode and the second upper electrode in the second direction.

The first pixel may further include a second transistor and a third transistor each including an active pattern and a gate electrode.

Each of the second pixel and the third pixel may include a capacitor, a first transistor, a second transistor, and a third transistor each including an active pattern and a gate electrode, and a light emitting element.

The light emitting element included in each of the first pixel, the second pixel, and the third pixel may include a first electrode, a second electrode, and a light emitting layer disposed between the first electrode and the second electrode.

The display panel may further include a pixel defining film in which openings exposing at least portions of the first electrodes of the unit pixel are defined, wherein the pixel area of each of the first pixel, the second pixel, and the third pixel may be defined by a corresponding one of the openings.

The pixel area of the first pixel may be spaced apart from the pixel area of the third pixel in the second direction, and the pixel area of the second pixel may be spaced apart from the pixel areas of the first pixel and the third pixel in a diagonal direction intersecting the first direction and the second direction intersecting the first direction.

The first pixel, the second pixel, and the third pixel may provide a same light.

An area of the pixel area of the first pixel may be smaller than an area of the pixel area of the second pixel and larger than an area of the pixel area of the third pixel.

At least a portion of the gate electrode may overlap the pixel area of the first pixel.

Among the data lines, a first data line electrically connected to the first pixel may be spaced apart from a second data line electrically connected to the second pixel in the first direction, with the active patterns of the first and second transistors disposed between the first and second data lines, and a third data line electrically connected to the third pixel and the first data line are spaced apart from each other in the first direction, with the second data line disposed between the third and first data lines.

The display panel may further include light shielding patterns overlapping the active pattern included in the second pixel and the active pattern included in the third pixel and spaced apart from each other in the second direction.

The light shielding patterns may be arranged between the first data line, the second data line, and the third data line.

The data lines and the light shielding patterns may include a same material.

The active pattern included in the second transistor of the first pixel may be integral with the second upper electrode.

The display panel may further include an encapsulation layer that covers the first pixel, the second pixel, and the third pixel and includes a first inorganic layer, a second inorganic layer, and an organic layer disposed between the first inorganic layer and the second inorganic layer.

The active pattern, the first upper electrode, and the second upper electrode may include a same material.

An area of the first upper electrode may be larger than an area of the second upper electrode.

The technical objectives to be achieved by the disclosure are not limited to those described herein, and other technical objectives that are not mentioned herein would be clearly understood by a person skilled in the art from the description of the disclosure.

### BRIEF DESCRIPTION OF THE DRAWINGS

The above and other objects and features of the disclosure will become apparent by describing in detail embodiments thereof with reference to the accompanying drawings.
FIG. 1A is a schematic perspective view of a display panel according to an embodiment of the disclosure.
FIG. 1B is a schematic perspective view of a curved display panel according to an embodiment of the disclosure.
FIG. 2A is a schematic cross-sectional view of the display panel according to an embodiment of the disclosure.
FIG. 2B is a schematic plan view of the display panel according to an embodiment of the disclosure.
FIG. 3 is a schematic diagram of an equivalent circuit of a pixel according to an embodiment of the disclosure.
FIG. 4 is a schematic enlarged plan view of a display area according to an embodiment of the disclosure.
FIG. 5A is a schematic plan view according to a stacking (or laminating) sequence of conductive patterns included in a unit pixel according to an embodiment of the disclosure.
FIG. 5B is a schematic cross-sectional view of the display panel along line I-I' of FIG. 5A.
FIG. 5C is a schematic cross-sectional view of the display panel along line I-I' of FIG. 5A.
FIGS. 6A to 6F are schematic plan views illustrating that the stacking sequence of the conductive patterns included in the unit pixel according to an embodiment of the disclosure is distinguished according to each layer.

### DETAILED DESCRIPTION OF THE EMBODIMENTS

It will be understood that when an element (or a region, a layer, a portion, or the like) is referred to as "being on", "connected to" or "coupled to" another element in the specification, it can be directly disposed on, connected or coupled to another element mentioned above, or intervening elements may be disposed therebetween.

The same reference numerals refer to the same components. Further, in the drawings, the thickness, the ratio, and the dimension of components may be exaggerated for effective description of technical contents. The expression "and/or" includes one or more combinations which associated components are capable of defining.

Although the terms "first", "second", etc. may be used to describe various components, the components should not be limited by the terms. The terms are only used to distinguish one component from another component. For example, without departing from the right scope of the disclosure, a first component may be referred to as a second component, and similarly, the second component may be also referred to as the first component. Singular expressions may include plural expressions unless clearly otherwise indicated in the context.

Also, the terms "under", "below", "on", "above", etc. are used to describe the correlation of components illustrated in drawings. The terms that are relative in concept are described based on a direction illustrated in drawings.

It will be understood that the terms "include", "comprise", "have", etc. specify the presence of features, numbers, steps, operations, elements, or components, described in the specification, or a combination thereof, and do not exclude in advance the presence or additional possibility of one or more other features, numbers, steps, operations, elements, or components or a combination thereof.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical terms and scientific terms) used in the specification have the same meaning as commonly understood by those skilled in the art to which the disclosure belongs. Furthermore, terms such as terms defined in the dictionaries commonly used should be interpreted as having a meaning consistent with the meaning in the context of the related technology, and should not be interpreted in overly ideal or overly formal meanings unless explicitly defined herein.

Hereinafter, an embodiment of the disclosure will be described with reference to accompanying drawings.

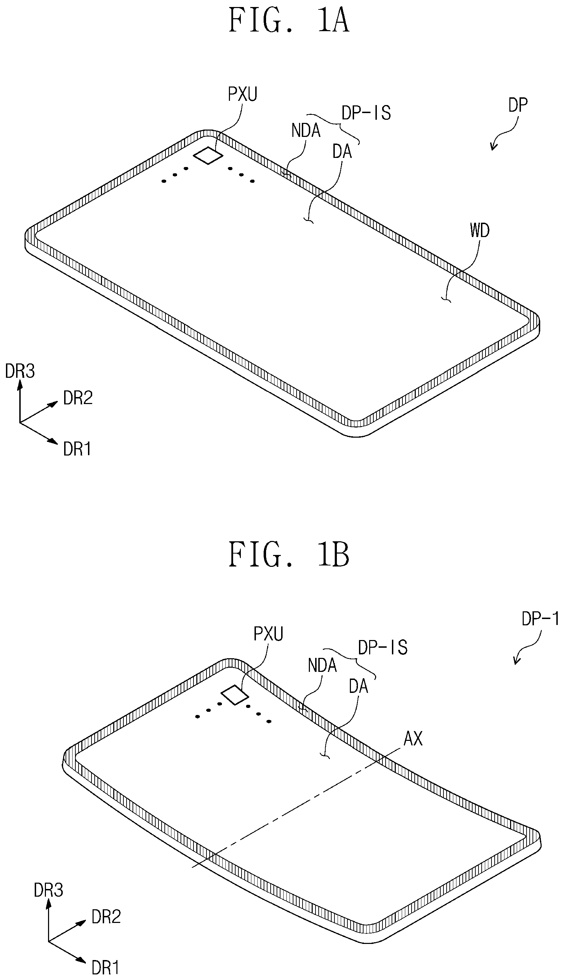

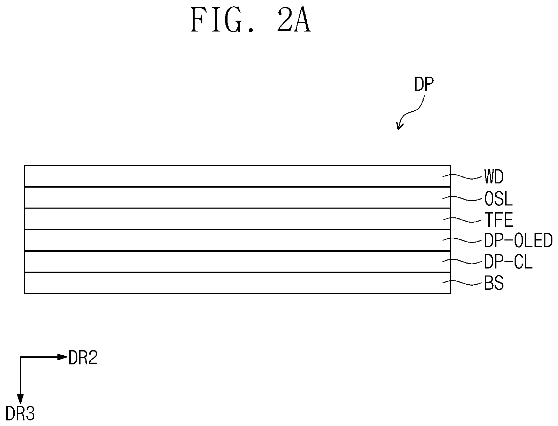

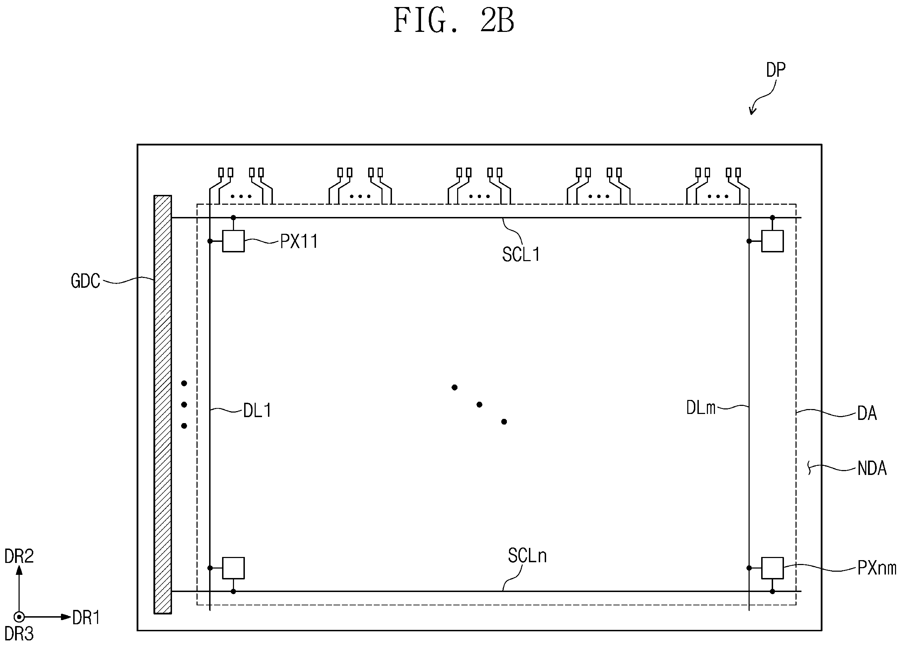

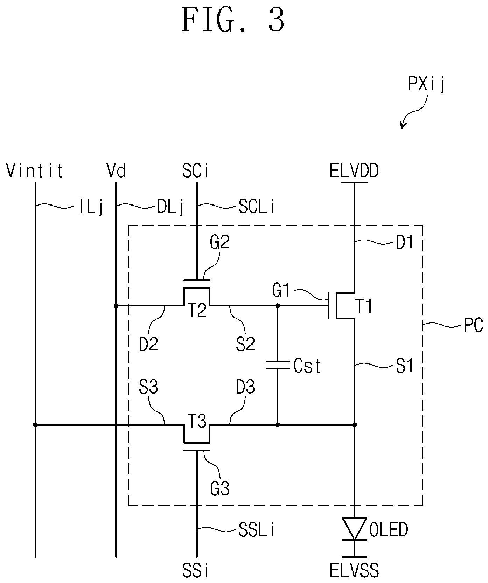

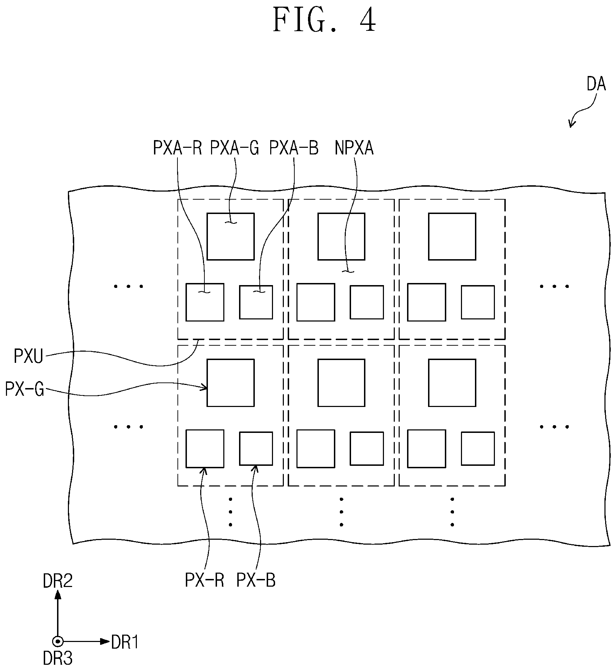

FIG. 1A is a schematic perspective view of a display panel according to an embodiment of the disclosure. FIG. 1B is a schematic perspective view of a curved display panel according to an embodiment of the disclosure. FIG. 2A is a schematic cross-sectional view of the display panel according to an embodiment of the disclosure. FIG. 2B is a schematic plan view of the display panel according to an embodiment of the disclosure. FIG. 3 is a schematic diagram of an equivalent circuit of a pixel according to an embodiment of the disclosure. FIG. 4 is a schematic enlarged plan view of a display area according to an embodiment of the disclosure.

Display panels DP and DP-1 illustrated in FIGS. 1A and 1B, which are light emitting display panels, may be one of a liquid crystal display panel, an electrophoretic display panel, a microelectromechanical system (MEMS) display panel, an electrowetting display panel, an organic light emitting display panel, an inorganic light emitting display panel, and a quantum-dot display panel. Further, the display panels DP and DP-1 according to an embodiment of the disclosure may include ultra-small light emitting elements. For example, the display panels DP and DP-1 may include micro light emitting diode (LED) elements and/or nano LED elements, but the disclosure is not particularly limited thereto.

Referring to FIG. 1A, the display panel DP may display an image through a display surface DP-IS. An upper surface of a member disposed on an uppermost side of the display panel DP may be defined as the display surface DP-IS. According to the disclosure, an upper surface of a window panel WD illustrated in FIG. 2A may be provided as the display surface DP-IS of the display panel DP.

The display surface DP-IS may be parallel to a plane defined by a first direction DR1 and a second direction DR2. A normal direction of the display surface DP-IS, for example, a thickness direction of the display panel DP, may indicate a third direction DR3. Hereinafter, front surfaces (or upper surfaces) and rear surfaces (or lower surfaces) of layers or units, which will be described below, are distinguished by the third direction DR3.

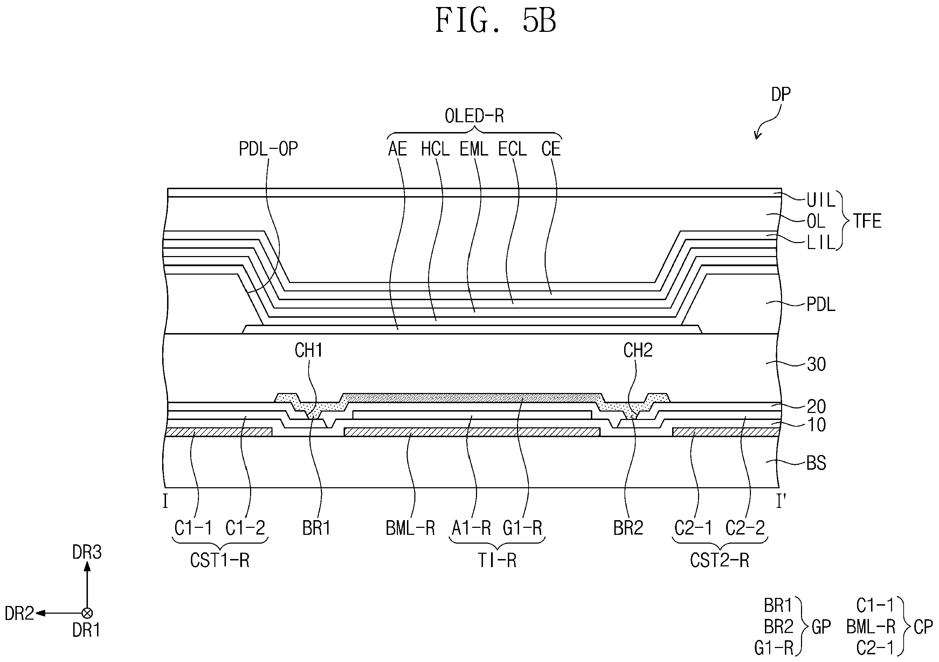

The display panel DP may include a display area DA and a non-display area NDA. A light emitting layer EML (see FIG. 5B) included in a pixel PXnm (see FIGS. 2A and 2B) may be disposed in the display area DA, and the light emitting layer EML (see FIG. 5B) of the pixel PXnm (see FIGS. 2A and 2B) is not disposed in the non-display area NDA, wherein, n and m are natural numbers greater than 0. The non-display area NDA is defined along an edge of the display surface DP-IS. The non-display area NDA may surround the display area DA. In an embodiment of the disclosure, the non-display area NDA may be omitted or disposed on only one side of the display area DA.

Referring to FIG. 1B, the display panel DP-1 according to an embodiment may be curved in the first direction DR1 with respect to a virtual axis AX extending in the second direction DR2. However, the disclosure is not limited thereto, and the virtual axis AX may extend in another direction (e.g., the first direction DR1) or the display panel DP-1 may be curved with respect to multiple axes extending in same and/or different directions.

According to an embodiment, the display panels DP and DP-1 may be a rollable display panel, a foldable display panel, or a slidable display panel. In this case, the display panels DP and DP-1 may be flexible and may be folded or rolled while installed in a display device. Accordingly, the display panels DP and DP-1 may include a curved display surface DP-IS or the three-dimensional display surface DP-IS. The three-dimensional display surface DP-IS may include multiple display areas DA facing in different directions.

FIGS. 1A and 1B illustrate that a unit pixel PXU is disposed in the display area DA. The unit pixel PXU may include at least two pixels PXnm that provide different lights. For example, the unit pixel PXU may be an area in which pixels PXnm that provide source lights are arranged. Light emitting areas, shapes, and an arrangement form of the pixels PXnm included in the unit pixel PXU are not limited to any particular one. For example, areas of the light emitting areas of the pixels PXnm (e.g., dimensions of the pixels PXnm) included in the unit pixel PXU may be different from each other. Further, each of the light emitting areas may have a circular shape or a polygonal shape on a plane.

Referring to FIGS. 2A and 2B, the display panel DP according to the disclosure may include a base layer BS, a circuit element layer DP-CL disposed on the base layer BS, a display element layer DP-OLED, an encapsulation layer TFE, a light control layer OSL, and/or the window panel WD. The display panel DP may further include functional layers such as a reflection preventing layer or a refractive index adjusting layer. The circuit element layer DP-CL may include at least one insulating layer and a circuit element. The insulating layers, which will be described below, may include organic layers and/or inorganic layers.

The base layer BS may include a resin layer, e.g., a synthetic resin layer. The synthetic resin layer may include, e.g., a thermosetting resin. In particular, the synthetic resin layer may include, e.g., at least one of an acrylic resin, a methacrylic resin, a polyisoprene, a vinyl resin, an epoxy resin, a urethane resin, a cellulose resin, a siloxane resin, a polyamide resin, and a perylene resin. The base layer BS may include, e.g., a glass substrate, a metal substrate, an organic/inorganic composite material substrate, or the like.

In the circuit element layer DP-CL, an insulating layer, a semiconductor layer, and a conductive layer may be formed through processes such as coating and deposition. Thereafter, the insulating layer, the semiconductor layer, and the conductive layer may be selectively patterned through photolithography and etching processes. A semiconductor pattern, a conductive pattern, a signal line or the like may be formed through these processes. The patterns arranged on the same layer may be formed through the same process.

The circuit element layer DP-CL may include a driving circuit or signal line constituting a pixel PX. The display element layer DP-OLED may include a light emitting element OLED (see FIG. 3) and a pixel defining film PDL (see FIG. 5B) included in the pixel PX.

The encapsulation layer TFE may be disposed on the display element layer DP-OLED to protect the light emitting element OLED. The encapsulation layer TFE may include inorganic layers and an organic layer disposed between the inorganic layers. The inorganic layers may protect the light emitting element OLED from moisture and oxygen, and the organic layer may protect the light emitting element OLED from foreign substances such as dust particles.

The light control layer OSL may include light control patterns that may change optical properties of a source light generated by the light emitting element OLED. The light control patterns may include quantum dots and may include color filter patterns that selectively transmit lights having passed through the light control patterns.

The window panel WD may be disposed on the display panel DP and transmit an image provided from the display panel DP to the outside. The window panel WD may distinguish the display area DA and the non-display area NDA of the display surface DP-IS as illustrated in FIG. 1A. A boundary between the display area DA and the non-display area NDA may be defined by a bezel pattern that is disposed under the window panel WD and absorbs a light.

The window panel WD may include a base layer BS and functional layers arranged on the base layer BS. The functional layers may include a protective layer, a fingerprint preventing layer, or the like. The base layer BS of the window panel WD may be made of, e.g., glass, sapphire, or plastic.

FIG. 2B illustrates an arrangement relationship between signal lines and pixels PX11 to PXnm included in the display panel DP on a plane. The signal lines SCL1 to SCLn and DL1 to DLm may include one or more scan lines SL1 to SLn and one or more data lines DL1 to DLm, wherein, n and m are natural numbers greater than 0.

The pixels PX11 to PXnm may be arranged in the display area DA. Each of the pixels PX11 to PXnm may be connected to a corresponding scan line among the scan lines SCL1 to SCLn and a corresponding data line among the plurality of data lines DL1 to DLm. Each of the pixels PX11 to PXnm may include a pixel driving circuit and a light emitting element. More types of signal lines may be provided on the display panel DP according to configurations of the pixel driving circuits of the pixels PX11 to PXnm.

A gate driving circuit GDC may be disposed in the non-display area NDA. The gate driving circuit GDC may be integrated into (or integral with) the display panel DP through a process, e.g., an oxide silicon gate (OSG) driver circuit process or an amorphous silicon gate (ASG) driver circuit process.

FIG. 3 illustrates as an example a schematic diagram of an equivalent circuit related to a pixel PXij among the pixels PX11 to PXnm, wherein, i and j are natural numbers greater than 0..

The pixel PXij may include a pixel circuit PC and the light emitting element OLED. The pixel circuit PC may include first to third transistors T1 to T3 and a capacitor Cst.

According to the disclosure, the pixel PXij may include capacitors Cst (e.g., a pair of capacitors Cst) spaced apart from each other and connected through the conductive pattern. A description related thereto will be made below.

The first to third transistors T1 to T3 may be formed through a low temperature polycrystalline silicon (LTPS) process or a low temperature polycrystalline oxide (LTPO) process. Each of the first to third transistors T1 to T3 may include, e.g., either a silicon semiconductor or an oxide semiconductor. In this case, the oxide semiconductor may include a crystalline or amorphous oxide semiconductor, the silicon semiconductor may include amorphous silicon, polycrystalline silicon or the like, and the disclosure is not limited to an embodiment.

Hereinafter, it will be described that the first to third transistors T1 to T3 are of N type, but the disclosure is not limited thereto, and each of the first to third transistors T1 to T3 may be a P-type transistor or an N-type transistor according to a signal applied thereto. In this case, a source area and a drain area of the P-type transistor may correspond to a drain area and a source area of the N-type transistor, respectively.

FIG. 3 illustrates as an example the pixel PXij connected to an ith scan line SCLi, an ith sensing line SSLi, a jth data line DLj, and a jth initial line ILj.

The pixel circuit PC may include the first transistor T1 (a driving transistor), the second transistor T2 (a switch transistor), the third transistor T3 (a sensing transistor), and the capacitor Cst. However, the pixel circuit PC may further include an additional transistor and an additional capacitor, and the disclosure is not limited to an embodiment.

The light emitting element OLED may be an organic light emitting element or inorganic light emitting element including an anode (a first electrode) and a cathode (a second electrode). The anode of the light emitting element OLED may receive a first voltage ELVDD through the first transistor T1, and the cathode of the light emitting element OLED may receive a second voltage ELVSS. The light emitting element OLED may emit a light by receiving the first voltage ELVDD and the second voltage ELVSS.

The first transistor T1 may include a drain area D1 that receives the first voltage ELVDD, a source area S1 connected to the anode of the light emitting element OLED, and a gate area G1 connected to the capacitor Cst. The first transistor T1 may control a driving current flowing through the light emitting element OLED from a voltage line of the first voltage ELVDD in response to a voltage value stored in the capacitor Cst.

The second transistor T2 may include a drain area D2 connected to the jth data line DLj, a source area S2 connected to the capacitor Cst, and a gate area G2 that receives an ith first scan signal SCi. The second transistor T2 may provide a data voltage Vd to the first transistor T1 in response to the ith first scan signal SCi.

The third transistor T3 may include a source area S3 connected to the jth initial line ILj, a drain area D3 connected to the anode of the light emitting element OLED, and a gate area G3 that receives an ith second scan signal SSi. The jth initial line ILj may receive an initial voltage Vintit.

The capacitor Cst may store various voltage difference values according to an input signal. For example, the capacitor Cst may store a voltage corresponding to a difference between a voltage received from the second transistor T2 and the first voltage ELVDD.

As illustrated in FIG. 4, a light generated by a first pixel PX-R may be provided to a first pixel area PXA-R, a light generated by a second pixel PX-G may be provided to a second pixel area PXA-G, and a light generated by a third pixel PX-B may be provided to a third pixel area PXA-B. The first to third pixel areas PXA-R, PXA-G, and PXA-B may correspond to openings PDL-OP defined in the pixel defining film PDL, which will be described in FIG. 5B.

A peripheral area NPXA may be disposed between the first pixel area PXA-R, the second pixel area PXA-G, and the third pixel area PXA-B. The peripheral area NPXA may set boundaries between the first to third pixel areas PXA-R, PXA-G, and PXA-B and prevents color mixing between the first to third pixel areas PXA-R, PXA-G, and PXA-B.

Each of the first to third pixels PX-R, PX-G, and PX-B may include the light emitting element OLED (see FIG. 5B), and the first to third pixels PX-R, PX-G, and PX-B may generate source lights having the same color. However, areas of light emitting areas (e.g., dimensions) of the first to third pixels PX-R, PX-G, and PX-B may be the same or different.

The source lights generated by the light emitting elements OLED (see FIG. 5B) of the first to third pixels PX-R, PX-G, and PX-B may be converted into lights having different colors through the first pixel area PXA-R, the second pixel area PXA-G, and the third pixel area PXA-B, and the converted source lights may be emitted. The emitted source lights may be converted into any one light having a red color, a green color, and a blue color through the light control patterns included in the light control layer OSL described in FIG. 2A.

Referring to FIG. 4, the first pixel area PXA-R and the third pixel area PXA-B may be arranged on the same row, and the second pixel area PXA-G may be disposed on a different row from that of the first pixel area PXA-R and the third pixel area PXA-B. For example, the first pixel area PXA-R and the third pixel area PXA-B may be spaced apart from each other in the first direction DR1, and the second pixel area PXA-G may be spaced from the first pixel area PXA-R and the third pixel area PXA-B in a direction diagonal to each of the first direction DR1 and the second direction DR2.

According to an embodiment, an area of the first pixel area PXA-R may be smaller than an area of the second pixel area PXA-G and larger than an area of the third pixel area PXA-B.

In an embodiment, the first pixel area PXA-R, the second pixel area PXA-G, and the third pixel area PXA-B having a square shape are illustrated as an example, but the arrangement form and the areas of the pixel areas are not limited thereto.

The arrangement structure of the first pixel area PXA-R, the second pixel area PXA-G, and the third pixel area PXA-B inside the unit pixel PXU illustrated in FIG. 4 is merely an example, but the disclosure is not limited thereto. In an embodiment of the disclosure, the first pixel area PXA-R, the second pixel area PXA-G, and the third pixel area PXA-B may be arranged in the first direction DR1 and arranged in the same row. Further, the arrangement of the first pixel area PXA-R, the second pixel area PXA-G, and the third pixel area PXA-B of each of the unit pixels PXU does not necessarily need to be the same.

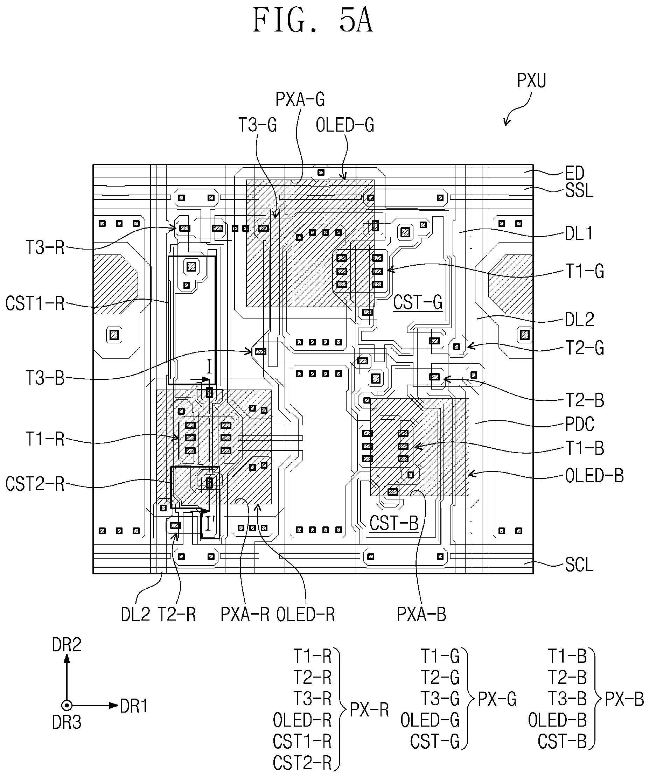

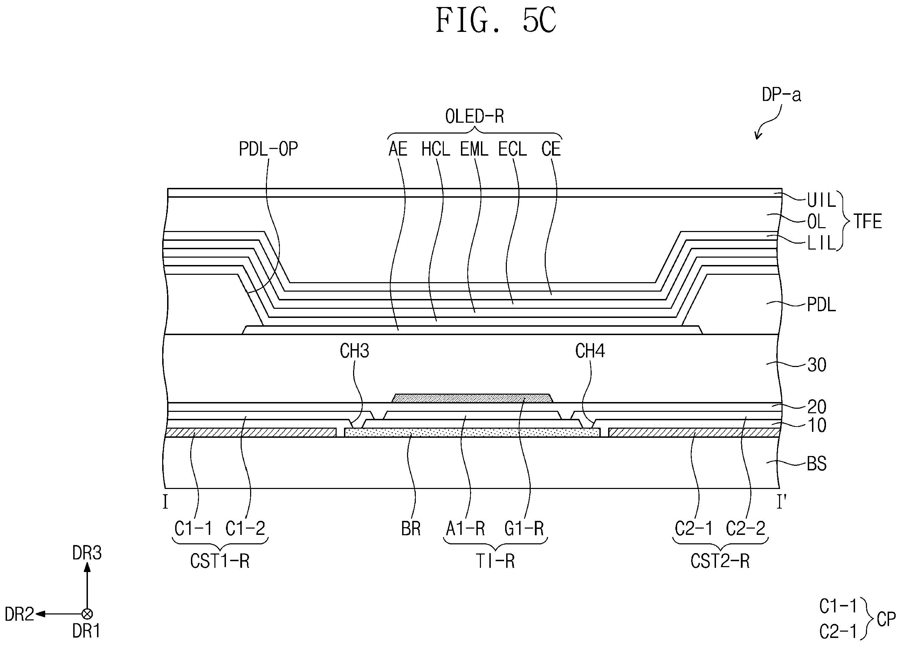

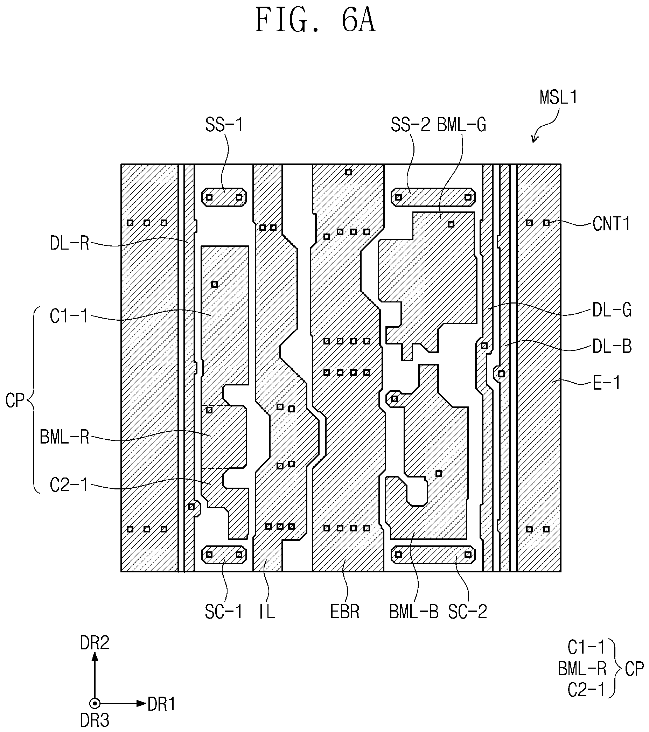

FIG. 5A is a schematic plan view according to a stacking sequence of conductive patterns included in a unit pixel according to an embodiment of the disclosure. FIG. 5B is a schematic cross-sectional view of the display panel along line I-I' of FIG. 5A. FIG. 5C is a schematic cross-sectional view of the display panel along line I-I' of FIG. 5A FIGS. 6A to 6F illustrate that the components illustrated in FIG. 5A may be separated according to each layer.

Referring to FIG. 5A, the unit pixel PXU may include the first to third pixels PX-R, PX-G, and PX-B. Each of the first to third pixels PX-R, PX-G, and PX-B may include the pixel circuit PC and the light emitting element OLED described in reference to FIG. 3.

For example, the first pixel PX-R may include first to third transistors T1-R, T2-R, and T3-R, capacitors CST1-R and CST2-R connected to each other, and a first light emitting element OLED-R. The second pixel PX-G may include first to third transistors T1-G, T2-G, and T3-G, a capacitor CST-G, and a second light emitting element OLED-G. The third pixel PX-B may include first to third transistors T1-B, T2-B, and T3-B, a capacitor CST-B, and a third light emitting element OLED-B.

For convenience of description, FIG. 5A illustrates the light emitting elements OLED-R, OLED-G, and OLED-B instead of first electrodes AE (see FIG. 5B) included in the first to third pixels PX-R, PX-G, and PX-B.

The source light generated by the first pixel PX-R may be provided to the first pixel area PXA-R, the source light generated by the second pixel PX-G may be provided to the second pixel area PXA-G, and the source light generated by the third pixel PX-B may be provided to the third pixel area PXA-B.

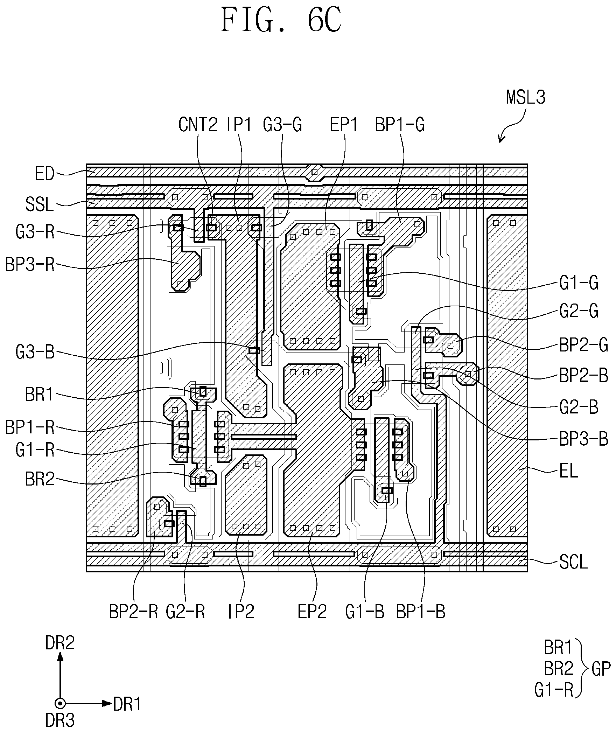

Each of the first to third pixels PX-R, PX-G, and PX-B may be connected to a first power line ED, a second power line EL (see, e.g., FIG. 6C), a scan line SCL, and a sensing line SSL. Further, the first to third pixels PX-R, PX-G, and PX-B may be connected to a corresponding one of data lines DL-R, DL-G, and DL-B. The first power line ED may provide the first voltage ELVDD (see FIG. 3), and the second power line EL may provide the second voltage ELVSS (see FIG. 3) lower than the first voltage ELVDD.

According to an embodiment, the data lines DL-R, DL-G, DL-B and the second power line EL may be spaced apart from each other in the first direction DR1 and extend in the second direction DR2. The first power line ED, the scan line SCL, and the sensing line SSL may be spaced apart from each other in the second direction DR2 and extend in the first direction DR1.

Referring to FIGS. 5A and 5B, the display panel DP according to an embodiment may include the base layer BS, insulating layers 10, 20, and 30 arranged on the base layer BS, the pixel defining film PDL in which the opening PDL-OP is defined, the encapsulation layer TFE, and the first pixel PX-R.

The first and second insulating layers 10 and 20 may include an inorganic film. For example, the inorganic layer may include a silicon oxide layer and a silicon nitride layer. Each of the silicon oxide layer and the silicon nitride layer may be provided in plurality and the silicon oxide layers and the silicon nitride layers may be alternately stacked. The third insulating layer 30 may be an organic layer.

The first pixel PX-R according to an embodiment may include the capacitors CST1-R and CST2-R connected to each other, the first transistor T1-R, and/or the first light emitting element OLED-R. According to an embodiment, the first pixel PX-R may further include a common electrode CP and a gate electrode GP. The first transistor T1-R may correspond to the first transistor T1 described in FIG. 3. Thus, the first pixel PX-R may include the second and third transistors T2 and T3 (corresponding to the second transistor T2-R and the third transistor T3-R) described in FIG. 3. Each of the second and third transistors T2 and T3 may include an active pattern and a gate pattern.

The description of the components included in the first light emitting element OLED-R may be equally applied to the light emitting elements OLED (see FIG. 3) included in the second and third pixels PX-G and PX-B.

The common electrode CP may be disposed on the base layer BS. The common electrode CP may include a first lower electrode C1-1, a first light shielding pattern BML-R, and a second lower electrode C2-1 spaced apart from each other in the second direction DR2. The first insulating layer 10 may be disposed on the base layer BS and cover (or overlap) the common electrode CP. The first lower electrode C1-1, the first light shielding pattern BML-R, and the second lower electrode C2-1 may be substantially a pattern and will be described separately for convenience of description.

A first upper electrode C1-2, a first active pattern A1-R, and a second upper electrode C2-2 may be arranged on the first insulating layer 10 and spaced apart from each other. The first upper electrode C1-2 may overlap the first lower electrode C1-1 to define the first capacitor CST1-R of the first pixel PX-R. The second upper electrode C2-2 may overlap the second lower electrode C2-1 to define the second capacitor CST2-R of the first pixel PX-R.

The first light shielding pattern BML-R may overlap the first active pattern A1-R and receive a bias voltage. The first light shielding pattern BML-R may receive the first voltage ELVDD (see FIG. 3). The first light shielding pattern BML-R may prevent an electric potential due to a polarization phenomenon from affecting the first transistor T1-R. Further, the first light shielding pattern BML-R may prevent an external light from reaching the first transistor T1-R. In an embodiment of the disclosure, the first light shielding pattern BML-R may also be a floating electrode that is isolated from other electrodes or wiring lines.

The gate electrode GP may include a first bridge part BR1, a gate pattern G1-R, and a second bridge part BR2 that are arranged sequentially in the second direction DR2. The first bridge part BR1, the gate pattern G1-R, and the second bridge part BR2 are substantially a pattern and will be described separately for convenience of description.

The gate pattern G1-R may overlap the first active pattern A1-R. A portion of the first active pattern A1-R, which overlaps the gate pattern G1-R, may be defined as a channel area, and an end and another end thereof spaced apart from each other with the channel area interposed therebetween may be defined as a source area and a drain area. The channel area may be a non-doped area or an area doped at a lower concentration than those of the source area and the drain area. The first active pattern A1-R and the gate pattern G1-R may be defined as the first transistor T1-R included in the first pixel PX-R.

The first bridge part BR1 may overlap a portion of the first upper electrode C1-2. The first bridge part BR1 may be connected to the first upper electrode C1-2 through a first contact hole CH1 defined in the second insulating layer 20.

The second bridge part BR2 may overlap a portion of the second upper electrode C2-2. The second bridge part BR2 may be connected to the second upper electrode C2-2 through a second contact hole CH2 defined in the second insulating layer 20. Thus, the first active pattern A1-R included in the first transistor T1-R may be disposed between the first capacitor CST1-R and the second capacitor CST2-R connected to each other.

According to the disclosure, the capacitors CST1-R and CST2-R included in the first pixel PX-R may be arranged in different areas, and thus electrodes included in the capacitors CST1-R and CST2-R may be arranged in a wide area within the unit pixel PXU. Thus, the display panel DP including the first pixel PX-R having improved driving characteristics by improving functions of the capacitors CST1-R and CST2-R may be provided.

The pixel defining film PDL may be disposed on the third insulating layer 30. The opening PDL-OP may be defined in the pixel defining film PDL. At least a portion of the first electrode AE may be exposed through the opening PDL-OP. One or more openings PDL-OP may be provided. The openings PDL-OP may correspond to the first to third pixel areas PXA-R, PXA-G, and PXA-B described in FIG. 4.

According to an embodiment, the pixel defining film PDL may have a property of absorbing a light, and for example, the pixel defining film PDL may have a black color. The pixel defining film PDL may include a black coloring agent. The black coloring agent may include black dye and black pigment. The black coloring agent may include carbon black, metal such as chromium, or an oxide thereof. The pixel defining film PDL may correspond to a light shielding pattern having light shielding characteristics.

The first electrode AE of the first light emitting element OLED-R may be disposed on the third insulating layer 30. The first electrode AE may be individually patterned for each pixel. A hole control layer HCL may be disposed on the first electrode AE and the pixel defining film PDL. The hole control layer HCL may include a hole transport layer and a hole injection layer. The light emitting layer EML may be disposed on the hole control layer HCL. An electronic control layer ECL may be disposed on the light emitting layer EML. The electron control layer ECL may include an electron transport layer and an electron injection layer. A second electrode CE may be disposed on the electron control layer ECL. According to an embodiment, the hole control layer HCL, the light emitting layer EML, the electron control layer ECL, and the second electrode CE may be common layers commonly formed in the first to third pixels PX-R, PX-G, and PX-B.

The encapsulation layer TFE may cover the first light emitting element OLED-R. The encapsulation layer TFE may include a first inorganic layer LIL, an organic layer OL, and a second inorganic layer UIL that are sequentially stacked. The inorganic layers LIL and UIL may include, e.g., a silicon nitride layer, a silicon oxy nitride layer, a silicon oxide layer, a titanium oxide layer, or an aluminum oxide layer. Each of the inorganic layers LIL and UIL may have a multi-layer structure. The organic layer OL may include an acryl-based organic layer, but the disclosure is not limited thereto.

The inorganic layers LIL and UIL may protect the first light emitting element OLED-R from moisture and oxygen, and the organic layer OL may protect the first light emitting element OLED-R from foreign substances such as dust particles

Referring to FIG. 5C, a display panel DP-a according to an embodiment may include the base layer BS, the insulating layers 10, 20, and 30 arranged on the base layer BS, the pixel defining film PDL in which the opening PDL-OP is defined, the encapsulation layer TFE, and/or the first pixel PX-R.

The first pixel PX-R according to an embodiment may include the capacitors CST1-R and CST2-R connected to each other, the first transistor T1-R, and the first light emitting element OLED-R. According to an embodiment, the first pixel PX-R may further include the common electrode CP and a bridge electrode BR. A difference from the configuration described in FIG. 5B will be mainly described below.

The common electrode CP may be disposed on the base layer BS. The common electrode CP may include the first lower electrode C1-1, a first light shielding pattern (not illustrated), and the second lower electrode C2-1 spaced apart from each other in the second direction DR2. The first insulating layer 10 may be disposed on the base layer BS and cover the common electrode CP.

The bridge electrode BR may be disposed on the base layer BS. The bridge electrode BR and the common electrode CP may be formed through a same process and include a same material. The bridge electrode BR may be spaced apart from the common electrode CP.

The first upper electrode C1-2 the first active pattern A1-R, and the second upper electrode C2-2 may be arranged on the first insulating layer 10 and spaced apart from each other.

A portion of the first upper electrode C1-2 may overlap the first lower electrode C1-1 to define the first capacitor CST1-R of the first pixel PX-R. Another portion of the first upper electrode C1-2 may overlap the bridge electrode BR. The first upper electrode C2-1 may be connected to the bridge electrode BR through a third contact hole CH3 defined in the first insulating layer 10.

A portion of the second upper electrode C2-2 may overlap the second lower electrode C2-1 to define the second capacitor CST2-R of the first pixel PX-R. Another portion of the second upper electrode C2-2 may overlap the bridge electrode BR. The second upper electrode C2-2 may be connected to the bridge electrode BR through a fourth contact hole CH4 defined in the first insulating layer 10.

The first active pattern A1-R may be disposed between the first upper electrode C1-2 and the second upper electrode C2-2. The gate pattern G1-R may be disposed on the second insulating layer 20 overlapping the first active pattern A1-R.

FIGS. 6A to 6F are schematic plan views illustrating that the stacking sequence of the conductive patterns included in the unit pixel according to an embodiment of the disclosure is distinguished according to each layer. Specifically, FIGS. 6A to 6F are schematic plan views illustrating that the stacking sequence of the conductive patterns described in FIG. 5A is distinguished according to each layer.

Referring to FIGS. 5A, 5B, and 6A, a first conductive layer MSL1 may be disposed on the base layer BS (see FIG. 5B) and covered by the first insulating layer 10. FIG. 6A illustrates together first contact holes CNT1 defined in the first insulating layer 10 and overlapping the first conductive layer MSL1.

The first conductive layer MSL1 may include the first data line DL-R, the common electrode CP, a first sensing pattern SS-1, a first scan pattern SC-1, the initial line IL, a power line EBR, a second sensing pattern SS-2, a second scan pattern SC-2, a second light shielding pattern BML-G, a third light shielding pattern BML-B, the second data line DL-G, the third data line DL-B, and/or a first line E-1.

The first data line DL-R may extend in the second direction DR2.

The common electrode CP may be spaced apart from the first data line DL-R in the first direction DR1 and extend in the second direction DR2. The common electrode CP may include the first lower electrode C2-1, the first light shielding pattern BML-R, and the second lower electrode C1-2 sequentially arranged in the second direction DR2.

The first sensing pattern SS-1 and the first scan pattern SC-1 may be spaced apart from each other in the second direction DR2 with the common electrode CP interposed therebetween.

The initial line IL may be spaced apart from the common electrode CP in the first direction DR1 and extend in the second direction DR2.

The power line EBR may be spaced apart from the initial line IL in the first direction DR1 and extend in the second direction DR2.

The second light shielding pattern BML-G may be spaced apart from the power line EBR in the first direction DR1. The third light shielding pattern BML-B may be spaced apart from the second light shielding pattern BML-G in the second direction DR2.

The second sensing pattern SS-2 and the second scan pattern SC-2 may be spaced apart from each other in the second direction DR2 with the second and third light shielding patterns BML-G and BML-B interposed therebetween.

The second data line DL-G may be spaced apart from the second and third light shielding patterns BML-G and BML-B in the first direction DR1 and extend in the second direction DR2. The third data line DL-B may be spaced apart from the second data line DL-G in the first direction DR1 and extend in the second direction DR2.

The first line E-1 may be spaced apart from the third data line DL-B in the first direction DR1 and extend in the second direction DR2.

Each of the first to third data lines DL-R, DL-G, and DL-B, the initial line IL, the power line EBR, and the first line E-1 may extend in the second direction DR2 and may be commonly disposed in the plurality of unit pixels PXU arranged in the second direction DR2.

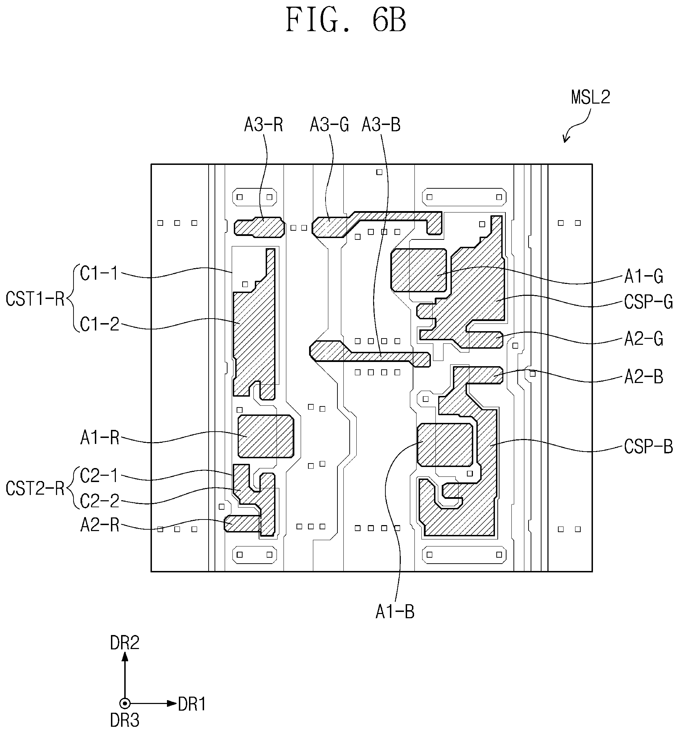

Referring to FIGS. 5A, 5B, and 6B, a second conductive layer MSL2 may be disposed on the first insulating layer 10 (see FIG. 5B) and covered by the second insulating layer 20 (see FIG. 5B).

The second conductive layer MSL2 may include first to third active patterns A1-R, A2-R, and A3-R included in the first pixel PX-R, first to third active patterns A1-G, A2-G, and A3-G included in the second pixel PX-G, and first to third active patterns A1-B, A2-B, and A3-B included in the third pixel PX-B. The second conductive layer MSL2 according to an embodiment may include the first upper electrode C1-2, the second upper electrode C2-2, a second capacitor pattern CSP-G, and a third capacitor pattern CSP-B.

The second active pattern A2-G of the second pixel PX-G and the second capacitor pattern CSP-G may be integral with each other and may be provided as an integrated pattern, and the second active pattern A2-B of the third pixel PX-B and the third capacitor pattern CSP-B may be integral with each other and may be provided as an integrated pattern.

The first active pattern A1-R of the first pixel PX-R may overlap the first light shielding pattern BML-R. The first upper electrode C1-2 may overlap the first lower electrode C1-1 to define the first capacitor CST1-R of the first pixel PX-R, and the second upper electrode C2-2 may overlap the second lower electrode C2-1 to define the second capacitor CST2-R of the first pixel PX-R.

The second active pattern A2-R of the first pixel PX-R may be integral with the second upper electrode C2-2.

The third active pattern A3-R of the first pixel PX-R may be spaced apart from the first upper electrode C1-2 in the second direction DR2 and may be disposed between the first sensing pattern SS-1 and the first lower electrode C1-1 on a plane.

A portion of the first active pattern A1-G of the second pixel PX-G may overlap the second light shielding pattern BML-G, and another portion may be disposed between the power line EBR and the second light shielding pattern BML-G on a plane.

The second capacitor pattern CSP-G of the second pixel PX-G may overlap the second light shielding pattern BML-G, and the second active pattern A2-G may protrude from the second capacitor pattern CSP-G in the first direction DR1. The second active pattern A2-G may not overlap the second light shielding pattern BML-G.

The third capacitor pattern CSP-B of the third pixel PX-B may overlap the third light shielding pattern BML-B, and the second active pattern A2-B may protrude from the third capacitor pattern CSP-B in the first direction DR1. The second active pattern A2-B may not overlap the third light shielding pattern BML-B.

The third active pattern A3-G of the second pixel PX-G may extend in the first direction DR1. An end and another end of the third active pattern A3-G, which are spaced apart from each other in the first direction DR1, may not overlap the power line EBR, and a portion between the end and the another end may overlap the power line EBR.

The third active pattern A3-B of the third pixel PX-B may be spaced apart from the third active pattern A3-G of the second pixel PX-G in the second direction DR2 and extend in the first direction DR1. An end and another end of the third active pattern A3-B, which are spaced apart from each other in the first direction DR1, may not overlap the power line EBR, and a portion between the end and the another end may overlap the power line EBR.

Referring to FIGS. 5A, 5B, and 6C, a third conductive layer MSL3 may be disposed on the second insulating layer 20 and covered by the third insulating layer 30. FIG. 6C illustrates together a second contact hole CNT2 defined in the second insulating layer 20 and overlapping the second conductive layer MSL2.

The third conductive layer MSL3 may include the first power line ED, the second power line EL, the sensing line SSL, the scan line SCL, first bridge patterns BP1-R, BP1-G, and BP1-B, second bridge patterns BP2-R, BP2-G, and BP2-B, the gate electrode GP, first gate patterns G1-G and G1-B, second gate patterns G2-R, G2-G, and G2-B, third bridge patterns BP3-R and BP3-B, third gate patterns G3-R, G3-G, and G3-B, first and second initial patterns IP1 and IP2, and/or first and second power patterns EP1 and EP2.

The first power line ED may extend in the first direction DR1. The first power line ED may be connected to the power line EBR through the first contact hole CNT1. The first power pattern EP1 and the second power pattern EP2 may be spaced apart from each other in the first direction DR1 and overlap the power line EBR. Each of the first power pattern EP1 and the second power pattern EP2 may be connected to the power line EBR through the first contact holes CNT1 and connected to the first power line ED through the power line EBR.

The first power pattern EP1 may be connected to the first active pattern A1-G through the second contact holes CNT2.

A portion of the second power pattern EP2 may be connected to the first active pattern A1-R through the second contact holes CNT2. Another portion of the second power pattern EP2 may be connected to the first active pattern A1-B through the second contact holes CNT2.

The second power line EL may extend in the second direction DR2. The second power line EL may be connected to the first line E-1 through the first contact holes CNT1.

The sensing line SSL may extend in the first direction DR1. The sensing line SSL may overlap the first sensing pattern SS-1 and the second sensing pattern SS-2. The sensing line SSL may be connected to the first sensing pattern SS-1 and the second sensing pattern SS-2 through the first contact holes CNT1.

The scan line SCL may extend in the first direction DR1. The scan line SCL may overlap the first scan pattern SC-1 and the second scan pattern SC-2. The scan line SCL may be connected to the first scan pattern SC-1 and the second scan pattern SC-2 through the first contact holes CNT1.

The bridge pattern BP1-R may overlap the first active pattern A1-R included in the first pixel PX-R, and a portion thereof may be connected to the first active pattern A1-R through the second contact holes CNT2. Another portion of the (1-1)th bridge pattern BP1-R may be connected to the first light shielding pattern BML-R of the common electrode CP through the first contact hole CNT1.

The (1-2)th bridge pattern BP1-G may overlap the first active pattern A1-G included in the second pixel PX-G, and a portion thereof may be connected to the first active pattern A1-G through the second contact holes CNT2. Another portion of the (1-2)th bridge pattern BP1-G may be connected to the third active pattern A3-G through the second contact hole CNT2. Another portion of the (1-2)th bridge pattern BP1-G may be connected to the second light shielding pattern BML-G through the first contact hole CNT1.

The bridge pattern BP1-B may overlap the first active pattern A1-B included in the third pixel PX-B, and a portion thereof may be connected to the first active pattern A1-B through the second contact holes CNT2. Another portion of the (1-3)th bridge pattern BP1-B may be connected to the third light shielding pattern BML-B through the first contact hole CNT1.

The (2-1)th bridge pattern BP2-R may overlap the second active pattern A2-R included in the first pixel PX-R, and a portion thereof may be connected to the second active pattern A2-R through the second contact hole CNT2. Another portion of the (2-1)th bridge pattern BP2-R may be connected to the first data line DL-R through the first contact hole CNT1.

The (2-2)th bridge pattern BP2-G may overlap the second active pattern A2-G included in the second pixel PX-G, and a portion thereof may be connected to the second active pattern A2-G through the second contact holes CNT2. Another portion of the (2-2)th bridge pattern BP2-G may be connected to the second data line DL-G through the first contact hole CNT1.

The (2-3)th bridge pattern BP2-B may overlap the second active pattern A2-B included in the third pixel PX-B, and a portion thereof may be connected to the second active pattern A2-B through the second contact hole CNT2. Another portion of the (2-3)th bridge pattern BP2-B may be connected to the third data line DL-B through the first contact hole CNT1.

The bridge pattern BP1-R may be connected to the first light shielding pattern BML-R of the common electrode CP through the first contact hole CNT1.

According to the disclosure, the gate electrode GP may include the first bridge part BR1, the (1-1)th gate pattern G1-R, and the second bridge part BR2 that are arranged sequentially in the second direction DR2. The first bridge part BR1, the (1-1)th gate pattern G1-R, and the second bridge part BR2 may be substantially a pattern and will be described separately for convenience of description.

The gate pattern G1-R may overlap the first active pattern A1-R. The first bridge part BR1 may overlap a portion of the first upper electrode C2-1. The first bridge part BR1 may be connected to the first upper electrode C2-1 through the second contact hole CNT2.

The second bridge part BR2 may overlap a portion of the second upper electrode C2-2. The second bridge part BR2 may be connected to the second upper electrode C2-2 through the second contact hole CNT2.

The gate pattern G1-G may overlap the first active pattern A1-G. The (1-2)th gate pattern G1-G may be connected to the second capacitor pattern CSP-G through the second contact hole CNT2.

The gate pattern G1-B may overlap the first active pattern A1-B. The (1-3)th gate pattern G1-B may be connected to the third capacitor pattern CSP-B through the second contact hole CNT2.

The gate pattern G2-R may overlap the second active pattern A2-R. The (2-1)th gate pattern G2-R may be a portion protruding from the scan line SCL in the second direction DR2.

The gate pattern G2-G may overlap the second active pattern A2-G. The (2-3)th gate pattern G2-B may overlap the second active pattern A2-B. The (2-2)th gate pattern G2-G and the (2-3)th gate pattern G2-B may be different portions that protrude from the scan line SCL in the second direction DR2.

The (3-1)th gate pattern G3-R may overlap the third active pattern A3-R. The (3-1)th gate pattern G3-R may be a portion protruding from the sensing line SSL in the second direction DR2.

The (3-2)th gate pattern G3-G may overlap the third active pattern A3-G. The (3-3)th gate pattern G3-B may overlap the third active pattern A3-B. The (3-2)th gate pattern G3-G and the (3-3)th gate pattern G3-B may be different portions that protrude from the sensing line SSL in the second direction DR2.

The (3-1)th bridge pattern BP3-R may overlap the third active pattern A3-R. A portion of the (3-1)th bridge pattern BP3-R may be connected to the third active pattern A3-R through the second contact hole CNT2, and another portion of the (3-1)th bridge pattern BP3-R may be connected to the first lower electrode C1-1 through the first contact hole CNT1.

The (3-2)th bridge pattern BP3-B may overlap the third active pattern A3-B. A portion of the (3-2)th bridge pattern BP3-B may be connected to the third active pattern A3-B through the second contact hole CNT2, and another portion of the (3-2)th bridge pattern BP3-B may be connected to the third light shielding pattern BML-B through the first contact hole CNT1.

The first and second initial patterns IP1 and IP2 may overlap the initial line IL. The first initial pattern IP1 may be connected to the initial line IL through the first contact holes CNT1 and connected to the third active patterns A3-R, A3-G, and A3-B through the second contact holes CNT2.

The initial pattern IP2 may be spaced apart from the first initial pattern IP1 in the second direction DR2 and connected to the initial line IL through the first contact holes CNT1.

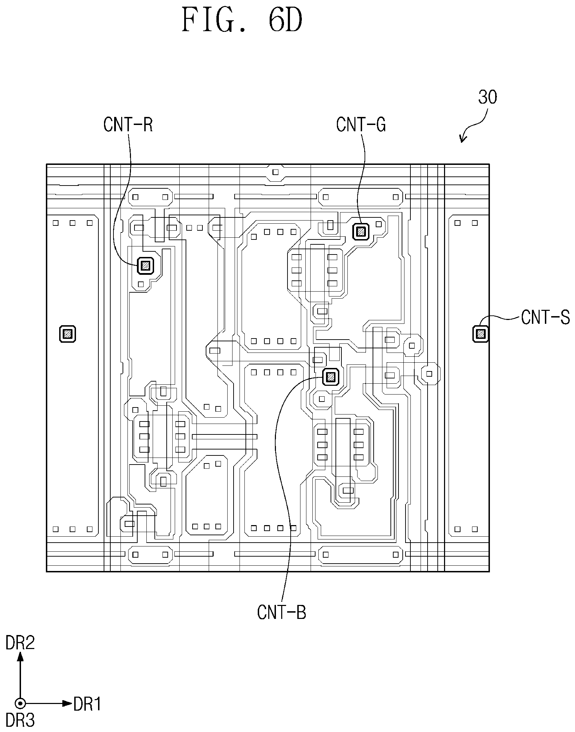

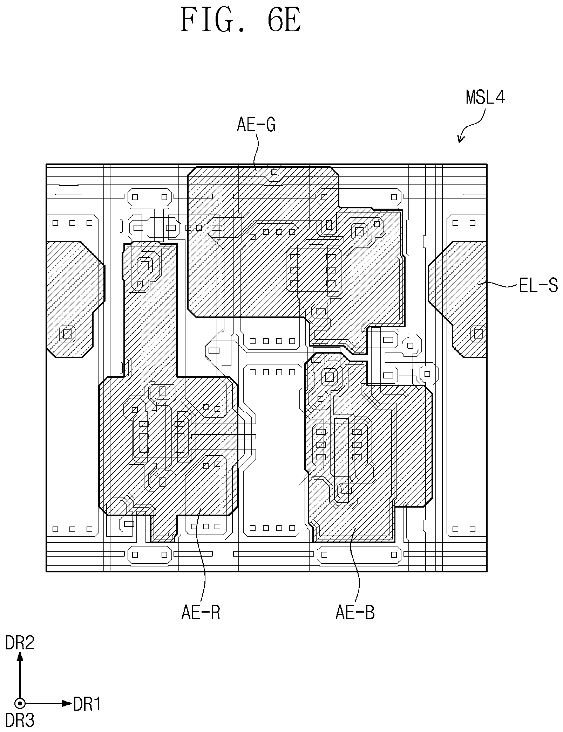

Referring to FIGS. 5A, 5B, 6D, and 6E, the third insulating layer 30 may be disposed on the second insulating layer 20 and cover the third conductive layer MSL3. Third contact holes CNT3 may be defined in the third insulating layer 30.

A (3-1)th contact hole CNT-R may expose the (3-1)th bridge pattern BP3-R, a (3-2)th contact hole CNT-G may expose the (1-2)th bridge pattern BP1-G, and a (3-3)th contact hole CNT-B may expose (3-2)th bridge pattern BP3-B. A (3-4)th contact hole CNT-S may expose the second power line EL.

Referring to FIG. 6E, a fourth conductive layer MSL4 may be disposed on the third insulating layer 30. The fourth conductive layer MSL4 may include a power pattern EL-S and first electrodes AE-R, AE-G, and AE-B.

The (1-1)th electrode AE-R may be connected to the (3-1)th bridge pattern BP3-R through the (3-1)th contact hole CNT-R, the (1-2)th electrode AE-G may be connected to the (1-2)th bridge pattern BP1-G through the (3-2)th contact hole CNT-G, and the (1-3)th electrode AE-B may be connected to the (3-2)th bridge pattern BP3-B through the (3-3)th contact hole CNT-B. The power pattern EL-S may be connected to the second power line EL through the (3-4)th contact hole CNT-S.

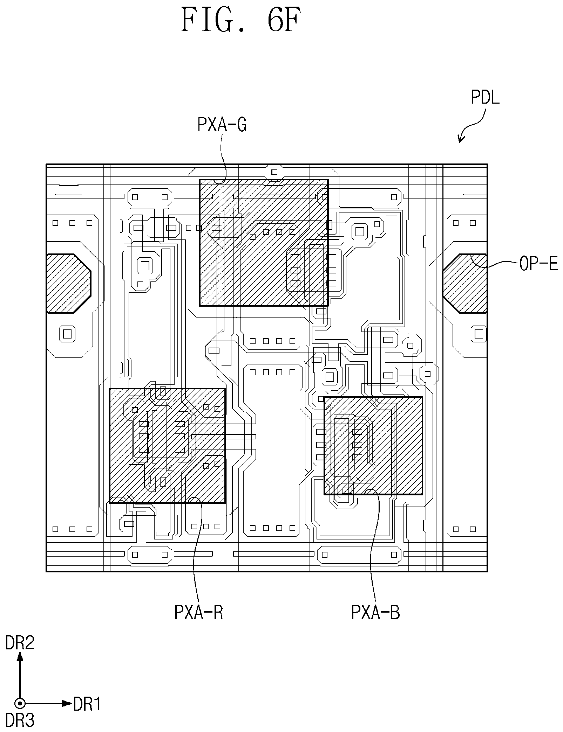

Referring to FIGS. 5A, 5B, and 6F, the pixel defining film PDL may be disposed on the fourth conductive layer MSL4. First to third openings PXA-R, PXA-G, and PXA-B and a power opening OP-E may be defined in the pixel defining film PDL. The first to third openings PXA-R, PXA-G, and PXA-B may correspond to the first to third pixel areas PXA-R, PXA-G, and PXA-B described in FIG. 4.

The first opening PXA-R may expose at least a portion of the (1-1)th electrode AE-R, the second opening PXA-G may expose at least a portion of the (1-2)th electrode AE-G, and the third opening PXA-B may expose at least a portion of the (1-3)th electrode AE-B. The power opening OP-E may expose at least a portion of the second power line EL, and the second electrode CE described in FIG. 5B may be connected to the power opening OP-E.

The above description is an example of technical features of the disclosure, and those skilled in the art to which the disclosure pertains will be able to make various modifications and variations. Thus, the embodiments of the disclosure described above may be implemented separately or in combination with each other.

The scope of the disclosure is not limited by these embodiments. The protection scope of the disclosure should be determined by the following claims.

## Claims

1. A display panel comprising:
data lines (DL1 to DLm) arranged on a base layer, spaced apart from one another in a first direction, and each extending in a second direction intersecting the first direction; and
a unit pixel electrically connected to the data lines and including a first pixel (PX-R), a second pixel (PX-G), and a third pixel (PX-B) each configured to provide a light to a pixel area, wherein
the first pixel (PX-R) includes:
a common electrode (CP) including a first lower electrode (C1-1), a light shielding pattern, and a second lower electrode (C1-2) sequentially arranged in the second direction;
a first upper electrode (C2-1) overlapping the first lower electrode and configured to a first capacitor with the first lower electrode;
a second upper electrode (C2-2) overlapping the second lower electrode and configured to a second capacitor with the second lower electrode;
a first transistor (T1-R) including:
an active pattern (A1-R) overlapping the light shielding pattern; and
a gate electrode (GP) overlapping the active pattern; and
a light emitting element (OLED-R) electrically connected to the first transistor, and
an end of the gate electrode (GP) is electrically connected to the first upper electrode (C2-1), and another end of the gate electrode (GP), which is spaced apart from the end in the second direction, is electrically connected to the second upper electrode.

2. The display panel of claim 1, further comprising:
a first insulating layer (10) disposed on the base layer and covering the common electrode;
a second insulating layer (20) disposed on the first insulating layer (10) and covering the first upper electrode (C2-1) and the second upper electrode (C2-2); and
a third insulating layer (30) disposed on the second insulating layer (20),
wherein the end of the gate electrode is electrically connected to the first upper electrode (C2-1) through a first contact hole defined in the second insulating layer (20), and the another end of the gate electrode is electrically connected to the second upper electrode through a second contact hole defined in the second insulating layer (20).

3. The display panel of claim 1 or 2, wherein the active pattern (A1-R), the first upper electrode (C2-1), and the second upper electrode (C2-2) are disposed on a same layer.

4. The display panel of any of the preceding claims, wherein the active pattern (A1-R) is disposed between the first upper electrode (C2-1) and the second upper electrode (C2-2) in the second direction.

5. The display panel of any of the preceding claims, wherein the first pixel (PX-R) further includes a second transistor (T2-R) and a third transistor (T3-R) each including an active pattern (A2-R, A3-R) and a gate electrode (GP).

6. The display panel of claim 5, wherein each of the second pixel (PX-G) and the third pixel (PX-B) includes a capacitor, a first transistor (T1-G, T1-B), a second transistor (T2-G, T2-B), and a third transistor (T3-G, T3-B) each including an active pattern and a gate electrode (GP), and a light emitting element.

7. The display panel of any of the preceding claims, wherein the light emitting element included in each of the first pixel (PX-R), the second pixel (PX-G), and the third pixel (PX-B) includes a first electrode, a second electrode, and a light emitting layer disposed between the first electrode and the second electrode.

8. The display panel of any of the preceding claims, further comprising:
a pixel defining film (PDL) in which openings exposing at least portions of the first electrodes of the unit pixel are defined,
wherein the pixel area of each of the first pixel, the second pixel, and the third pixel is defined by a corresponding one of the openings.

9. The display panel of claim 8, wherein
the pixel area of the first pixel is spaced apart from the pixel area of the third pixel in the second direction, and
the pixel area of the second pixel is spaced apart from the pixel areas of the first pixel and the third pixel in a diagonal direction intersecting the first direction and the second direction intersecting the first direction.

10. The display panel of claim 9, wherein the first pixel, the second pixel, and the third pixel provide a same light.

11. The display panel of claim 10, wherein an area of the pixel area of the first pixel is smaller than an area of the pixel area of the second pixel and larger than an area of the pixel area of the third pixel.

12. The display panel of claim 10, wherein at least a portion of the gate electrode (GP) overlaps the pixel area of the first pixel.

13. The display panel of claim 6, wherein
among the data lines, a first data line electrically connected to the first pixel is spaced apart from a second data line electrically connected to the second pixel in the first direction, with the active patterns of the first and second transistors disposed between the first and second data lines, and
a third data line electrically connected to the third pixel and the first data line are spaced apart from each other in the first direction, with the second data line disposed between the third and first data lines.

14. The display panel of claim 13, further comprising:
light shielding patterns overlapping the active pattern included in the second pixel and the active pattern included in the third pixel and spaced apart from each other in the second direction.

15. The display panel of claim 14, wherein the light shielding patterns are arranged between the first data line, the second data line, and the third data line.

## Patentansprüche

1. Anzeigetafel, umfassend:
Datenleitungen (DL1 bis DLm), die auf einer Trägerschicht angeordnet sind, in einer ersten Richtung voneinander beabstandet sind und sich jeweils in einer zweiten Richtung erstrecken, die die erste Richtung schneidet; und
ein Einheitspixel, das mit den Datenleitungen elektrisch verbunden ist und ein erstes Pixel (PX-R), ein zweites Pixel (PX-G) und ein drittes Pixel (PX-B) umfasst, die jeweils dazu konfiguriert sind, ein Licht an einen Pixelbereich bereitzustellen, wobei
das erste Pixel (PX-R) Folgendes umfasst:
eine gemeinsame Elektrode (CP), die eine erste untere Elektrode (C1-1), ein Lichtabschirmmuster und eine zweite untere Elektrode (C1-2) umfasst, die in der zweiten Richtung nacheinander angeordnet sind;
eine erste obere Elektrode (C2-1), die die erste untere Elektrode überlappt und mit der ersten unteren Elektrode zu einem ersten Kondensator konfiguriert ist;
eine zweite obere Elektrode (C2-2), die die zweite untere Elektrode überlappt und mit der zweiten unteren Elektrode zu einem zweiten Kondensator konfiguriert ist;
einen ersten Transistor (T1-R), umfassend:
ein aktives Muster (A1-R), das das Lichtabschirmmuster überlappt; und
eine Gate-Elektrode (GP), die das aktive Muster überlappt; und
ein lichtemittierendes Element (OLED-R), das mit dem ersten Transistor elektrisch verbunden ist;
wobei ein Ende der Gate-Elektrode (GP) mit der ersten oberen Elektrode (C2-1) elektrisch verbunden ist; und wobei ein anderes Ende der Gate-Elektrode (GP), das von dem Ende in der zweiten Richtung beabstandet ist, mit der zweiten oberen Elektrode elektrisch verbunden ist.

2. Anzeigetafel nach Anspruch 1, ferner umfassend:
eine erste Isolationsschicht (10), die auf der Trägerschicht angeordnet ist und die gemeinsame Elektrode bedeckt;
eine zweite Isolationsschicht (20), die auf der ersten Isolationsschicht (10) angeordnet ist und die erste obere Elektrode (C2-1) und die zweite obere Elektrode (C2-2) bedeckt; und
eine dritte Isolationsschicht (30), die auf der zweiten Isolationsschicht (20) angeordnet ist,
wobei sich das Ende der Gate-Elektrode mit der ersten oberen Elektrode (C2-1) durch ein erstes Kontaktloch, das in der zweiten Isolationsschicht (20) definiert ist, elektrisch verbunden ist; und wobei das andere Ende der Gate-Elektrode mit der zweiten oberen Elektrode durch ein zweites Kontaktloch, das in der zweiten Isolationsschicht (20) definiert ist, elektrisch verbunden ist.

3. Anzeigetafel nach Anspruch 1 oder 2, wobei sich das aktive Muster (A1-R), die erste obere Elektrode (C2-1) und die zweite obere Elektrode (C2-2) auf einer gleichen Schicht befinden.

4. Anzeigetafel nach einem der vorhergehenden Ansprüche, wobei sich das aktive Muster (A1-R) zwischen der ersten oberen Elektrode (C2-1) und der zweiten oberen Elektrode (C2-2) in der zweiten Richtung befindet.

5. Anzeigetafel nach einem der vorhergehenden Ansprüche, wobei das erste Pixel (PX-R) ferner einen zweiten Transistor (T2-R) und einen dritten Transistor (T3-R) umfasst, die jeweils ein aktives Muster (A2-R, A3-R) und eine Gate-Elektrode (GP) umfassen.

6. Anzeigetafel nach Anspruch 5, wobei jedes des zweiten Pixels (PX-G) und des dritten Pixels (PX-B) einen Kondensator, einen ersten Transistor (T1-G, T1-B), einen zweiten Transistor (T2-G, T2-B) und einen dritten Transistor (T3-G, T3-B), die jeweils ein aktives Muster und eine Gate-Elektrode (GP) umfassen, und ein lichtemittierendes Element umfasst.

7. Anzeigetafel nach einem der vorhergehenden Ansprüche, wobei das lichtemittierende Element, das in jedem des ersten Pixels (PX-R), des zweiten Pixels (PX-G) und des dritten Pixels (PX-B) enthalten ist, eine erste Elektrode, eine zweite Elektrode und eine lichtemittierende Schicht umfasst, die sich zwischen der ersten Elektrode und der zweiten Elektrode befindet.

8. Anzeigetafel nach einem der vorhergehenden Ansprüche, ferner umfassend:
eine pixeldefinierende Schicht (PDL), in der Öffnungen definiert sind, die zumindest Abschnitte der ersten Elektroden des Einheitspixels freilegen,
wobei der Pixelbereich von jedem des ersten Pixels, des zweiten Pixels und des dritten Pixels durch eine entsprechende der Öffnungen definiert ist.

9. Anzeigetafel nach Anspruch 8, wobei
der Pixelbereich des ersten Pixels von dem Pixelbereich des dritten Pixels in der zweiten Richtung beabstandet ist und
der Pixelbereich des zweiten Pixels von den Pixelbereichen des ersten Pixels und des dritten Pixels in einer die erste Richtung schneidenden diagonalen Richtung und der die erste Richtung schneidenden zweiten Richtung beabstandet ist.

10. Anzeigetafel nach Anspruch 9, wobei das erste Pixel, das zweite Pixel und das dritte Pixel ein gleiches Licht bereitstellen.

11. Anzeigetafel nach Anspruch 10, wobei eine Fläche des Pixelbereichs des ersten Pixels kleiner als eine Fläche des Pixelbereichs des zweiten Pixels und größer als eine Fläche des Pixelbereichs des dritten Pixels ist.

12. Anzeigetafel nach Anspruch 10, wobei zumindest ein Abschnitt der Gate-Elektrode (GP) den Pixelbereich des ersten Pixels überlappt.

13. Anzeigetafel nach Anspruch 6, wobei
unter den Datenleitungen eine erste Datenleitung, die mit dem ersten Pixel elektrisch verbunden ist, von einer zweiten Datenleitung, die mit dem zweiten Pixel elektrisch verbunden ist, in der ersten Richtung beabstandet ist, wobei sich die aktiven Muster der ersten und zweiten Transistoren zwischen den ersten und zweiten Datenleitungen befinden, und
wobei eine dritte Datenleitung, die mit dem dritten Pixel elektrisch verbunden ist, und die erste Datenleitung in der ersten Richtung voneinander beabstandet sind, wobei sich die zweite Datenleitung zwischen den dritten und ersten Datenleitungen befindet.

14. Anzeigetafel nach Anspruch 13, ferner umfassend:
Lichtabschirmmuster, die das in dem zweiten Pixel enthaltene aktive Muster und das in dem dritten Pixel enthaltene aktive Muster überlappen und voneinander in der zweiten Richtung beabstandet sind.

15. Anzeigetafel nach Anspruch 14, wobei die Lichtabschirmmuster zwischen der ersten Datenleitung, der zweiten Datenleitung und der dritten Datenleitung angeordnet sind.

## Revendications

1. Panneau d'affichage, comportant :
des lignes de données (DL1 à DLm) agencées sur une couche de base, espacées les unes des autres dans une première direction, et s'étendant chacune dans une deuxième direction croisant la première direction ; et
un pixel unitaire connecté électriquement aux lignes de données et incluant un premier pixel (PX-R), un deuxième pixel (PX-G) et un troisième pixel (PX-B) configurés chacun pour fournir une lumière à une zone de pixel, dans lequel
le premier pixel (PX-R) inclut :
une électrode commune (CP) incluant une première électrode inférieure (C1-1), un motif de protection contre la lumière et une deuxième électrode inférieure (C1-2) agencés séquentiellement dans la deuxième direction ;
une première électrode supérieure (C2-1) chevauchant la première électrode inférieure et configurée sur un premier condensateur avec la première électrode inférieure ;
une deuxième électrode supérieure (C2-2) chevauchant la deuxième électrode inférieure et configurée sur un deuxième condensateur avec la deuxième électrode inférieure ;
un premier transistor (T1-R) incluant :
un motif actif (A1-R) chevauchant le motif de protection contre la lumière ; et
une électrode grille (GP) chevauchant le motif actif ; et
un élément émetteur de lumière (OLED-R) connecté électriquement au premier transistor, et
une extrémité de l'électrode grille (GP) est connectée électriquement à la première électrode supérieure (C2-1), et une autre extrémité de l'électrode grille (GP), qui est espacée de l'extrémité dans la deuxième direction, est connectée électriquement à la deuxième électrode supérieure.

2. Panneau d'affichage selon la revendication 1, comportant en outre :
une première couche isolante (10) disposée sur la couche de base et recouvrant l'électrode commune ;
une deuxième couche isolante (20) disposée sur la première couche isolante (10) et recouvrant la première électrode supérieure (C2-1) et la deuxième électrode supérieure (C2-2) ; et
une troisième couche isolante (30) disposée sur la deuxième couche isolante (20),
dans lequel l'extrémité de l'électrode de grille est connectée électriquement à la première électrode supérieure (C2-1) à travers un premier trou de contact défini dans la deuxième couche isolante (20), et l'autre extrémité de l'électrode de grille est connectée électriquement à la deuxième électrode supérieure à travers un deuxième trou de contact défini dans la deuxième couche isolante (20).

3. Panneau d'affichage selon la revendication 1 ou 2, dans lequel le motif actif (A1-R), la première électrode supérieure (C2-1) et la deuxième électrode supérieure (C2-2) sont disposés sur une même couche.

4. Panneau d'affichage selon l'une quelconque des revendications précédentes, dans lequel le motif actif (A1-R) est disposé entre la première électrode supérieure (C2-1) et la deuxième électrode supérieure (C2-2) dans la deuxième direction.

5. Panneau d'affichage selon l'une quelconque des revendications précédentes, dans lequel le premier pixel (PX-R) comporte en outre un deuxième transistor (T2-R) et un troisième transistor (T3-R) incluant chacun un motif actif (A2-R, A3-R) et une électrode de grille (GP).

6. Panneau d'affichage selon la revendication 5, dans lequel chacun du deuxième pixel (PX-G) et du troisième pixel (PX-B) comporte un condensateur, un premier transistor (T1-G, T1-B), un deuxième transistor (T2-G, T2-B), et un troisième transistor (T3-G, T3-B) incluant chacun un modèle actif et une électrode de grille (GP), et un élément émetteur de lumière.

7. Panneau d'affichage selon l'une quelconque des revendications précédentes, dans lequel l'élément émetteur de lumière inclus dans chacun du premier pixel (PX-R), du deuxième pixel (PX-G) et du troisième pixel (PX-B) comporte une première électrode, une deuxième électrode et une couche émettrice de lumière disposée entre la première électrode et la deuxième électrode.

8. Panneau d'affichage selon l'une quelconque des revendications précédentes, comportant en outre :
un film définissant des pixels (PDL) dans lequel des ouvertures exposant au moins des parties des premières électrodes du pixel unitaire sont définies,
dans lequel la zone de pixel de chacun du premier pixel, du deuxième pixel et du troisième pixel est définie par l'une correspondante des ouvertures.

9. Panneau d'affichage selon la revendication 8, dans lequel
la zone de pixel du premier pixel est espacée de la zone de pixel du troisième pixel dans la deuxième direction, et
la zone de pixel du deuxième pixel est espacée des zones de pixel du premier pixel et du troisième pixel dans une direction diagonale croisant la première direction et la deuxième direction croisant la première direction.

10. Panneau d'affichage selon la revendication 9, dans lequel le premier pixel, le deuxième pixel et le troisième pixel fournissent une même lumière.

11. Panneau d'affichage selon la revendication 10, dans lequel une aire de la zone de pixel du premier pixel est plus petite qu'une aire de la zone de pixel du deuxième pixel et plus grande qu'une aire de la zone de pixel du troisième pixel.

12. Panneau d'affichage selon la revendication 10, dans lequel au moins une partie de l'électrode grille (GP) chevauche la zone de pixel du premier pixel.

13. Panneau d'affichage selon la revendication 6, dans lequel
parmi les lignes de données, une première ligne de données connectée électriquement au premier pixel est espacée d'une deuxième ligne de données connectée électriquement au deuxième pixel dans la première direction, les motifs actifs des premier et deuxième transistors étant disposés entre les première et deuxième lignes de données, et
une troisième ligne de données connectée électriquement au troisième pixel et la première ligne de données sont espacées l'une de l'autre dans la première direction, la deuxième ligne de données étant disposée entre les troisième et première lignes de données.

14. Panneau d'affichage selon la revendication 13, comportant en outre :
des motifs de protection contre la lumière chevauchant le motif actif inclus dans le deuxième pixel et le motif actif inclus dans le troisième pixel et étant espacés l'un de l'autre dans la deuxième direction.

15. Panneau d'affichage selon la revendication 14, dans lequel les motifs de protection contre la lumière sont agencés entre la première ligne de données, la deuxième ligne de données et la troisième ligne de données.
